Europäisches Patentamt

European Patent Office

Office européen des brevets

(19)

(11) Publication number: **0 248 381 B1**

# EUROPEAN PATENT SPECIFICATION

(45) Date of publication of patent specification: **18.12.91**    (51) Int. Cl.⁵: **G05F 1/46**

(21) Application number: **87107898.6**

(22) Date of filing: **01.06.87**

(54) **Power voltage regulator circuit.**

(30) Priority: **31.05.86 JP 126339/86**

(43) Date of publication of application:
**09.12.87 Bulletin 87/50**

(45) Publication of the grant of the patent:
**18.12.91 Bulletin 91/51**

(84) Designated Contracting States:
**DE FR GB**

(56) References cited:
**EP-A- 0 113 458**
**EP-A- 0 152 805**
**EP-A- 0 214 899**
**US-A- 4 649 291**

(73) Proprietor: **KABUSHIKI KAISHA TOSHIBA**
**72, Horikawa-cho Saiwai-ku**
**Kawasaki-shi Kanagawa-ken(JP)**

(72) Inventor: **Tsujimoto, Jun-ichi c/o Patent Division**
**Kabushiki Kaisha Toshiba 1-1 Shibaura**
**1-chome**
**Minato-ku Tokyo(JP)**

(74) Representative: **Henkel, Feiler, Hänzel & Partner**
**Möhlstrasse 37**
**W-8000 München 80(DE)**

## Description

The present invention relates to a power voltage regulator circuit for lowering a power voltage, which is supplied from the outside, as an internal power source within a semiconductor integrated circuit (IC) device.

The integration density of a semiconductor IC device has recently been increased with rapidity. For example, in a large-scale integrated (LSI) memory device, MOS transistors having a gate length of a submicron order are employed to form a memory unit. Submicron MOS transistors prone to be adversely affected in a high electric field, and, therefore, they need to be operated with a power voltage lower than 5V which is generally employed in a computer system. A power voltage regulator circuit is formed within a single semiconductor chip along with a memory unit, in order to a power voltage of a predetermined level.

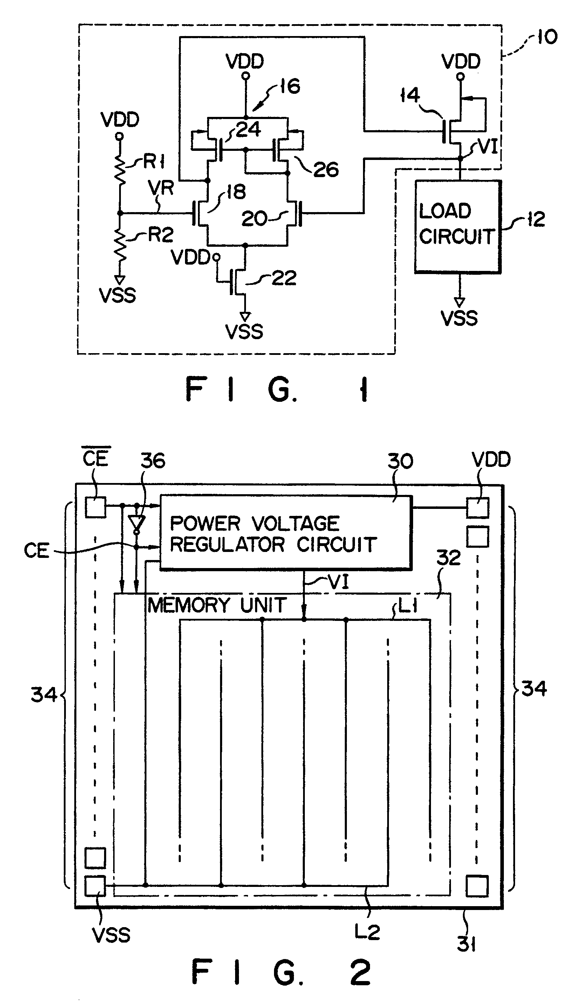

Fig. 1 shows conventional power voltage regulator circuit 10. Load circuit 12 is an integrated circuit, for example, a memory unit, and is operated with internal power voltage VI produced from regulator circuit 10. Regulator circuit 10 includes P-channel MOS transistor 14, which serves as a variable resistor, and differential amplifier 16 for controlling a gate voltage of MOS transistor 14. The source of MOS transistor 14 is connected to power terminal VDD to which an external power voltage is supplied. The drain of MOS transistor I4 serves as an output terminal of regulator circuit I0, from which internal power voltage VI is produced. Load circuit I2 is connected between the drain of MOS transistor I4 and power terminal VSS set to the ground potential. The source of MOS transistor I4 is electrically connected to a back gate, that is, a semiconductor region having a surface area which serves as a channel of MOS transistor I4, so that the semiconductor region is set to a potential equal to that of power terminal VDD.

Differential amplifier I6 comprises N-channel MOS transistors I8 and 20 constituting a differential pair, N-channel MOS transistor 22 serving as a constant voltage source, and P-channel MOS transistors 24 and 26 constituting a current mirror load. Resistor elements RI and R2 are connected in series between power terminals VDD and VSS, thereby to form a voltage divider that generates reference voltage VR. Reference voltage VR is supplied to the gate of MOS transistor I8, and an output voltage of regulator circuit I0, or internal power voltage VI, is fed to the gate of MOS transistor 20. When a current flows through load circuit I2, a voltage drop occurs in MOS transistor I4, and internal power voltage VI is made lower than the external power voltage. Differential amplifier I6 compares internal power voltage VI and reference voltage VR, and controls the gate of MOS transistor I4 so as to reduce the difference between voltages VI and VR.

Regulator circuit I0 is, however, not suitable for an LSI device of the type which is required to be operated with a small power consumption. In the design of a static-type random access memory (SRAM), there is a case in which the power consumption is limited to 50mA or less. Differential amplifier I6 of a current-mirror type consumes relatively large amount of current, that is, about 5-6mA. Therefore, it is difficult to satisfy the requirement of the power consumption, without degrading the characteristics of the SRAM.

Prior art document EP-A-0 152 805 describes a semiconductor device which has power source terminals for receiving a power source voltage and a voltage converting circuit for generating an output voltage which is lower than the power source voltage. This voltage converting circuit has a constant voltage circuit for generating a reference voltage which is lower than the power source voltage, a voltage drop circuit which is connected to the power source terminal, and a differential amplifying circuit for controlling the conductivitiy of the voltage drop circuit in accordance with a difference between the output voltage of the voltage drop circuit and the reference voltage. This differential amplifying circuit generates a control voltage which linearly varies at a gentle slope in response to a change in feedback voltage near the reference voltage.

It is an object of the present invention to provide a power voltage regulator circuit whose power consumption is small.

To solve this object the present invention provides a power voltage regulator circuit as described in claim 1.

In the power voltage regulator circuit of the present invention, when the external power voltage is set to a value higher than a predetermined value, a constant voltage lower than the external power voltage is fed to the gate of the MIS transistor from the constant voltage generator. When a load current flows, a voltage drop occurs in the MIS transistor, and the potential of the output line is set to a level lower than the gate voltage by the amount of the threshold voltage of the MIS transistor. In the case where the potential of the semiconductor body is equalized to that of the source of the MIS transistor, as mentioned above, the variation in the threshold voltage due to the backgate bias effect can be prevented. Further, if the increase in the load current results in the decrease in the potential of the output line, the potential of the semiconductor body varies in accordance with the decrease in the potential of the output line, to increase the conductivity of the MIS transistor. In other words, the decrease in the potential of the output line is automatically compensated. In the present invention, there is no need to set the operation current of the constant voltage generator to such a high level as is employed in the conventional current mirror type differential amplifier wherein the gate voltage of the MIS transistor is controlled with reference to the potential of the output line. The power consumption of the power voltage regulator circuit can be reduced.

This invention can be more fully understood from the following detailed description when taken in conjunction with the accompanying drawings, in which:

Fig. 1 shows a conventional power voltage regulator circuit;

Fig. 2 is a top view of a semiconductor memory chip in which a power voltage regulator circuit according to an embodiment of the invention is formed;

Fig. 3 shows the circuit configuration of the power voltage regulator circuit shown in Fig. 2;

Fig. 4 shows the detailed structure of a voltage drop section in the circuit of Fig. 3;

Fig. 5 is a graph for explaining the output characteristics of constant voltage generators 52 and 54 shown in Fig. 3; and

Fig. 6 is a graph for explaining the operation of the power voltage regulator circuit shown in Fig. 2, and showing the relationship between the internal power voltage and the external power voltage.

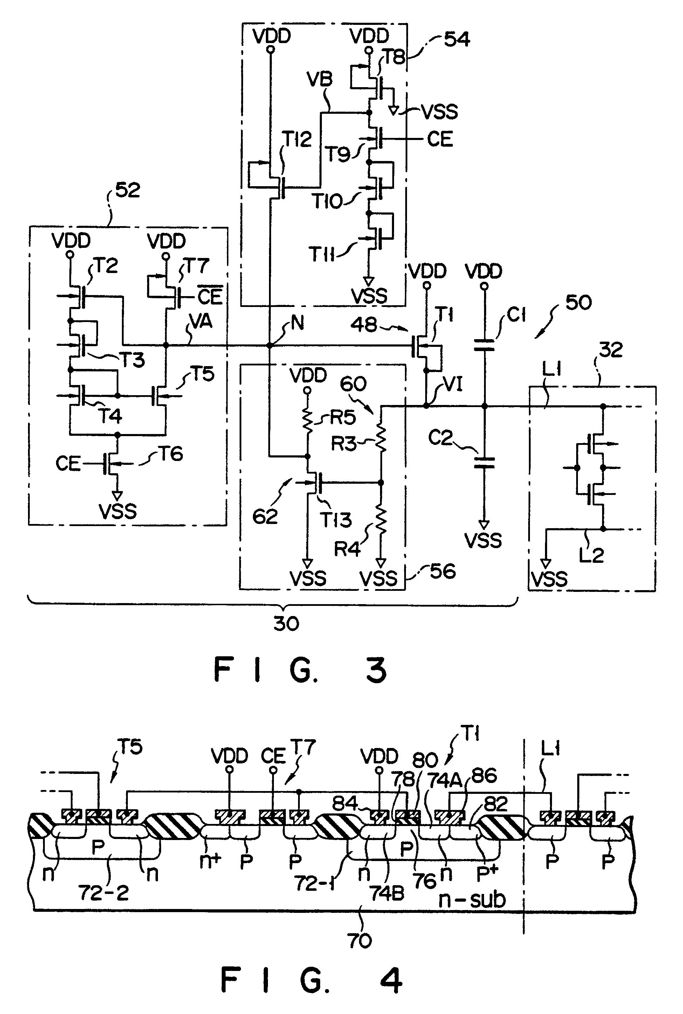

A power voltage regulator circuit according to an embodiment of the invention will now be described with reference to accompanying Figs. 2-6.

Fig. 2 schematically shows the power voltage regulator circuit of the invention. Power voltage regulator circuit 30 is formed within semiconductor chip 31 along with an LSI circuit, for example, memory unit 32. Bonding pads 34 are formed on the circumference of memory chip 31, and serve as power terminals VDD and VSS, chip enable terminal CE, and other input/output terminals. An external power voltage is applied to power terminal VDD. Power terminal VSS is set to the ground potential. Regulator circuit 30 is connected between power terminals VDD and VSS. Output lines LI and L2 are connected to an output terminal of regulator circuit 30 and power terminal VSS, respectively. Memory unit 32 is connected between output lines LI and L2. A chip enable signal is supplied from the outside to chip enable terminal CE when memory unit 32 is accessed. The potential of chip enable terminal CE is set to 0V upon receipt of the chip enable signal, and is kept at 5V in other state. Chip enable terminal CE is connected to regulator circuit 30 and memory unit 32, directly and through inverter 36. Other terminals are connected to memory unit 34. Memory unit 34 has a number of static memory cells each constituted by submicron MOS transistors, and a controller for selecting the memory cells and for writing/reading out data in/from the selected memory cells.

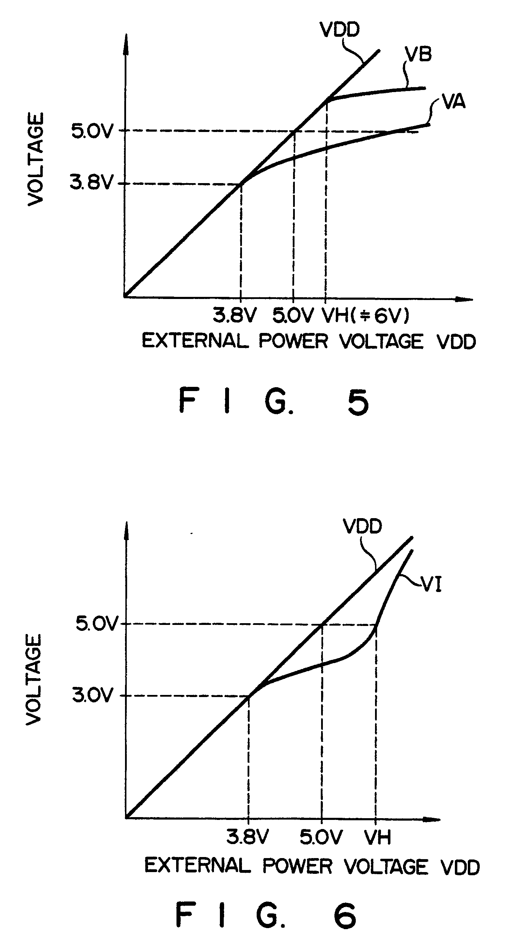

Fig. 3 shows power voltage regulator circuit 30 in detail. Regulator circuit 30 includes voltage-drop section 48 and ripple filter 50 for smoothing internal power voltage VI. Voltage-drop section 48 has N-channel MOS transistor TI. The drain of MOS transistor TI is connected to power terminal VDD. The source and back gate of MOS transistor TI are connected each other and to output line LI. The source of MOS transistor TI serves as an output terminal of regulator circuit 30. Namely, a source voltage of MOS transistor TI is fed to memory unit 32 as internal power voltage VI. Ripple filter 50 is constituted by capacitance CI and capacitance C2. Capacitance CI is connected between power terminal VDD and output line LI, and capacitance C2 is connected between output line LI and power terminal VSS.

Regulator circuit 30 includes first and second constant voltage generators 52 and 54, and bias circuit 56, in order to control the gate voltage of MOS transistor TI. Constant voltage generator 52 comprises N-channel MOS transistors T2, T3, T4, T5, T6 and P-channel MOS transistor T7. The drain of MOS transistor T2 is connected to terminal VDD. The source and gate of MOS transistor T3 are connected to each other and to the source of MOS transistor T2. The source and gate of MOS transistor T4 are connected to each other and to the source of MOS transistor T3. The gate of MOS transistor T5 is connected to a junction between the drain of MOS transistor T4 and the source of MOS transistor T3. The drain of MOS transistor T5 is connected to the drain of MOS transistor T7. The source and back gate of MOS transistor T7 are connected to each other and to power terminal VDD. The gate of MOS transistor T7 is connected to chip enable terminal $\overline{CE}$, shown in Fig. 2. The drain of MOS transisor T6 is connected to the sources of MOS transistors T4 and T5. The source of MOS transistor T6 is connected to power terminal VSS. The gate of MOS transistor T6 is connected to output terminal CE of inverter 36, shown in Fig. 2. A junction between the drains of MOS transistors T5 and T7 serves as an output terminal of constant voltage generator 52 and is connected to the gates of MOS transistors TI and T2. In constant voltage generator 52, MOS transistors T5 and T6 serve as a current mirror load, and MOS transistor T7 serves as a pull-up transistor. Constant voltage generator 52 has a low current consumption property. This property is derived from the fact that MOS transistor T2 has a gate connected to node N, MOS transistor T4 on the input side of the current mirror load is series-connected to MOS transistor T2, and an output terminal of MOS transistor T5 on the output side of the current mirror load is connected to node N.

Constant voltage generator 54 is constituted by P-channel MOS transistors T8 and TI2 and N-channel MOS transistors T9, TI0, and TII. The source and back gate of MOS transistor T8 are connected to each other and to power terminal VDD. The gate of MOS transistor T8 is connected to power terminal VSS. The gate of MOS transistor T9 is connected to output terminal CE of inverter 36, shown in Fig. 2. The drain of MOS transistor T9 is connected to the drain of MOS transistor T8. The gate and drain of MOS transistor TI0 are connected to each other and to the source of MOS transistor 9. The gate and drain of MOS transistor TII are connected to each other and to the source of MOS transistor TI0. The source of MOS transistor TII is connected to power terminal VSS. The gate of MOS transistor TI2 is connected to a junction of the drains of MOS transistors T8 and T9. The source and back gate of MOS transistor TI2 are connected to each other and to power terminal VDD. The drain of MOS transistor TI2 is connected to the gate of MOS transistor TI, and serves as an output terminal of constant voltage generator 54. In constant voltage generator 54, MOS transistor TI2 serves as a pull-up transistor.

Bias circuit 56 includes voltage-divider 60 and inverter 62. Voltage divider 60 comprises resistors R3 and R4 which are connected in series between output line LI and power terminal VSS. Inverter 62 is constituted by resistor R5 and transistor TI3. Resistor R5 is connected at one end to power terminal VDD and serves as a load. Transistor TI3 has a gate connected to a junction between resistors R3 and R4 and a current path connected between the other end of resistor R5 and power terminal VSS. The resistance values of resistors R3, R4, and R5 are set to 8GΩ, 2GΩ, and 2GΩ, respectively.

Fig. 4 shows in detail the structure of the voltage drop section. Semiconductor chip 3I has N-type substrate 70 and P-type wells 72-I, 72-2,..., formed in the surface area of substrate 70. For example, N-type regions 74A and 74B are formed in the surface area of well 72-I, and serve as a source and a drain of MOS transistor TI. A region of the surface area of well 72-I, which is located between N-type regions 74A and 74B, serves as channel region 76 of the MOS transistor TI. Oxide film 78 is formed over channel region 76. Gate electrode 80 of MOS transistor TI is formed on oxide film 76. P$^+$-type contact region 82 is formed in the surface area of well 72-I. Drain electrode 84 of MOS transistor TI is formed on region 74B, and is connected to power terminal VDD. Source electrode 86 of MOS transistor TI is formed on regions 74A and 82, and is connected to output line LI. Well 72-I serves as a back gate of MOS transistor TI, and is electrically connected to source region 74A through regions 82 and 86. The potential of well 72-I is equal to that of source region 74A.

Fig. 5 is a graph for explaining the output characteristics of constant voltage generators 52 and 54. The output voltages of constant voltage generators 52 and 54 are constant if external power voltage VDD is unchanged. Curve VA shows the dependency of the drain voltage of MOS transistor T7 on external power voltage VDD. Curve VB shows the dependency of the gate voltage of MOS transistor TI2 on external power voltage VDD. The drain voltage (VA) of MOS transistor T7 is equal to external power voltage VDD when external power voltage VDD is fixed to a level in a range from 0 to 3.8V. When external power voltage VDD is fixed to a level higher than 3.8V, the drain voltage (VA) is maintained at a lower level than external power voltage VDD. The gate voltage (VB) of MOS transistor TI2 is maintained at a level equal to that of external power voltage VDD when external power voltage VDD is fixed at a level in a range from 0 to 6V. When external power voltage VDD is fixed to a level higher than 6V, the gate voltage (VB) of MOS transistor TI2 is maintained at a lower level than external power voltage VDD. Supposing that the voltage levels at which the saturation of voltages VA and VB begins are represented by VHA and VHB, VHA ( = 3.8V) is lower than a standard value ( = 5V) of external power voltage VDD, and VHB ( = 6V) is higher than the standard value of VDD.

The operation of the above-mentioned power voltage regulator circuit will now be described. Memory unit 32 is set in the standby state when a chip enable signal is not fed to terminal CE. In the standby state, a low level voltage ( = 0V) and a high level voltage ( = 5V) are supplied to the gates of MOS transistors T6 and T7 of constant voltage generator 52, respectively. MOS transistors T6 and T7 are, then, turned off, thereby setting the power consumption of voltage generator 52 to zero. Voltage generator 52 is kept in a non-operating state. Similarly, when memory unit 32 is in the standby state, the gate of MOS transistor T9 of voltage generator 54 receives a low level voltage ( = 0V). MOS transistor T9 is turned off, thereby keeping voltage generator 54 in a non-operating state. Irrespective of the state of memory unit 32, bias circuit 56 is kept in an operating state. Memory unit 32 is not accessed in the standby state. At this time, the conductivity of MOS transistor TI is controlled under the output voltage of bias circuit 56, and sets internal power voltage VI to a predetermined level, for example, to 4 V, during the period in which memory unit 32 is not accessed.

Memory unit 32 is set in an active state when a chip enable signal is supplied to terminal $\overline{CE}$. In the active state, a high level voltage (=5V) and a low level voltage (=0V) are supplied to the gates of MOS transistors T6 and T7 of constant voltage generator 52, respectively, and a high level voltage (=5V) is supplied to the gate of MOS transistor T9 of voltage generator 54. MOS transistors T6 and T7 are, then, turned off, thereby setting voltage generator 52 in the operating state. MOS transistor T9 is turned on, thereby setting voltage generator 54 in the operating state.

Fig. 6 shows the relationship between internal power voltage VI and external power voltage VDD. When external power voltage VDD is equal to or lower than VHB (=6V), MOS transistor TI2 of voltage generator 54 receives gate voltage VB which is equal to external power voltage VDD, so that MOS transistor TI2 is turned off. At this time, the potential of node N is equalized to output voltage VA of constant voltage generator 52, and is utilized as a gate voltage for MOS transistor TI. When voltage VA is within the range from 3.8 V to VHB (=6V), internal power voltage VI is made lower than output voltage VA by a an amount corresponding to threshold voltage of MOS transistor TI. The back gate, or well 72-I, of MOS transistor TI is not connected to substrate 70, but to region 74 serving as a source. Thus, the threshold voltage of MOS transistor TI is kept constant without being affected by the back gate bias effect.

In the life testing time, external power voltage VDD is set at a higher level than VHB, for example, 7 V. The life testing is performed during the manufacturing step or at the time of delivery, in order to test the life of products selected at random. When external power voltage VDD is set at a higher level than VHB, MOS transistor TI2 of constant voltage generator 54 receives gate voltage VB which is lower than external power voltage VDD, so that MOS transistor TI2 is turned on. Thus, the potential of node N is set higher than output voltage VA of constant voltage generator 52. Internal power voltage VI is set at a level lower than the potential of node N by an amount corresponding to a threshold voltage of MOS transistor TI.

In the above embodiment, N-channel MOS transistor TI is provided in voltage drop section 48, and the drain and source of MOS transistor TI are connected to power terminal VDD and output line LI, respectively. The back gate of MOS transistor TI is connected to the source thereof, and is set to a potential of output line LI. When the potential of output line LI is lowered due to increase in a load current, the potential of the back gate varies in accordance with the potential decrease in output line LI, thus increasing the conductivity of the MOS transistor. As a result, a potential change in output line LI is automatically curbed, and no current mirror type differential amplifier needs to be used in order to control the voltage drop section.

The power voltage regulator circuit is controlled by a chip enable signal. Constant voltage generators 52 and 54 are turned off when memory unit 32 is in the standby state. At this time, bias circuit 56 supplies a gate voltage to MOS transistor TI. Since the resistance values of resistors R3, R4, and R5 of bias circuit 56 are sufficiently high, bias circuit 56 consumes a very small amount of current, for example, several tens of nA. When memory unit 32 is in the active state, constant voltage generators 52 and 54 are rendered operative. Constant voltage generator 54 is used only when internal power voltage VI needs to be increased for life testing. When external power voltage VDD is set to a standard level (=5V) which is lower than VHB, constant voltage generator 52 controls the gate voltage of MOS transistor TI. Constant voltage generator 52 consumes the current of several tens of μA. In this embodiment, a current consumption can be sufficiently reduced, compared to a current mirror type differential amplifier which consumes the current of several mA.

In the above embodiment, constant voltage generators 52 and 54 and bias circuit 56 may be modified if the basic functions of these devices are unchanged. Even if modifications are made, a current consumption can be reduced, as in the above embodiment.

Bias circuit 56 and constant voltage generator 54 may not be provided in the voltage regulator circuit. Constant voltage generator 52 may be constituted such that it constantly generates a constant voltage without being controlled by a chip enable signal.

In the present invention, a control circuit, whose power consumption is low, compared to a current mirror type differential amplifier, can be used to control the gate voltage of the MOS transistor of the voltage drop section. Therefore, the power consumption of an LSI device including a power voltage regulator circuit can be reduced. The power voltage regulator circuit of this invention is suitable for an LSI device such as a SRAM. The present invention can easily satisfy the requirements concerning the power consumption of an LSI device, which are difficult to meet in the prior art.

## Claims

1. A power voltage regulator circuit comprising:
   - a power terminal (VDD) for receiving an external power voltage;
   - an output line (L1);
   - voltage-drop means (48) for lowering the external power voltage, said voltage-drop means (48) including an n-channel MIS transistor (T1) having a drain connected to said power terminal (VDD), a source connected to said output line (L1), a gate, and a semiconductor body (72-1) whose surface region serves as a channel (76) of said MIS transistor (T1); and

- a first constant voltage generator (52), connected to said power terminal (VDD), for generating an output voltage (VA) lower than said external power voltage when said external power voltage is higher than a first predetermined level, and supplying the generated output voltage (VA) to the gate of said MIS transistor (T1) of said voltage-drop means (48), thereby supplying to said output line (L1) an internal power voltage (VI) which is lower than the generated output voltage (VA) by the threshold voltage of said MIS transistor (T1),

characterized in that

- said semiconductor body (72-1) is electrically connected to the source of said MIS transistor (T1).

2. A power voltage regulator circuit according to claim 1, characterized in that said first constant voltage generator (52) includes an output node connected to the gate of said MIS transistor (T1), a pull-up means (T7) connected between said power terminal (VDD) and the output node, a variable resistor means (T2) connected at one end to said power terminal (VDD), for supplying a current in accordance with the potential of said output node, a load circuit (T4, T5, T6) of a current mirror type having an input load (T4) connected to the other end of said variable resistor means (T2), and an output load connected to the output node.

3. A power voltage regulator circuit according to claim 2, characterized in that said output line (L1) is connected to an integrated circuit (32) serving as a load, and said first constant voltage generator (52) is responsive to a chip-enable signal (CE) which is supplied when said integrated circuit (32) is made active.

4. A power voltage regulator circuit according to claim 3, characterized in that said variable resistor means includes an n-channel MIS transistor (T2), said load circuit includes a pair of first and second n-channel MIS transistors (T4, T5), as said input and output loads, and a third n-channel MIS transistor (T6), and said pull-up means includes a p-channel MIS transistor (T7).

5. A power voltage regulator circuit according to claim 4, characterized in that the n-channel MIS transistor (T2) of said variable resistor means has a gate connected to said output node and a drain connected to said power terminal (VDD), the first n-channel MIS transistor (T4) of said load circuit has a drain connected to receive a drain current from the MIS transistor (T2) of said variable resistor means and a gate connected to the drain thereof, the second n-channel MIS transistor (T5) of said load circuit has a drain connected to said output node, and a gate connected to the drain of said first n-channel MIS transistor (T4), the third n-channel MIS transistor (T6) of said load circuit has a current path connected at one end to the sources of said first and second n-channel MIS transistors (T4, T5) and grounded at the other end, and a gate connected to receive a chip-enable signal (CE), and the p-channel MIS transistor (T7) of said pull-up means has a current path connected between said power terminal (VDD) and output node, and a gate connected to receive an inversion signal of said chip-enable signal (CE).

6. A power voltage regulator circuit according to claim 1, characterized by further comprising a second constant voltage generator (54), for generating an output voltage (VB) higher than the output voltage (VA) of said first constant voltage generator (52) when the external power voltage is higher than a second predetermined level, which is higher than said first predetermined level and a standard level of said external power voltage.

7. A power voltage regulator circuit according to claim 6, characterized in that said second constant voltage generator (54) includes an output node connected to the gate of said MIS transistor (T1) of said voltage-drop means (48), a pull-up means (T12) connected between said power terminal (VDD) and the output node of the second constant voltage generator (54), and a driver (T8, T9, T10, T11) for driving the pull-up means (T12) of said second constant voltage generator (54), in accordance with said external power voltage.

8. A power voltage regulator circuit according to claim 7, characterized in that said pull-up means of the second constant voltage generator (54) is a p-channel MIS transistor (T12) having a source connected to said power terminal (VDD), a drain connected to the output node of the second constant voltage generator (54), and a gate, said driver includes a p-channel MIS transistor (T8) and a plurality of n-channel MIS transistors (T9, T10, T11), said p-channel MIS transistor (T8) of the driver has a gate grounded, a drain connected to said power terminal (VDD), and a source connected to the gate of said p-channel MIS transistor (T12) of the pull-up means of said second constant voltage generator (54), and said n-channel MIS transistros (T9, T10, T11) of the driver have current paths connected in series between the source of said p-channel MIS tansistor (T8) of the driver and ground.

9. A power voltage regulator circuit according to claim 1, characterized by further comprising a bias circuit (56) for supplying a stand-by bias voltage to the gate of said n-channel MIS transistor (T1) of the voltage-drop means.

10. A power voltage regulator circuit according to claim 9, characterized in that said bias circuit (56) includes series-connected resistive elements (R3, R4) for dividing the potential of the output line (L1), and an inverter (62) responsive to the output voltage of said resistive elements (R3, R4), for generating an output voltage as said stand-by bias voltage.

**Revendications**

1. Circuit régulateur de tension d'alimentation comprenant :
    une borne d'alimentation (VDD) destinée à recevoir une tension d'alimentation ;
    une ligne de sortie (L1) ;
    un moyen d'abaissement de tension (48) pour abaisser la tension d'alimentation externe, ledit moyen d'abaissement de tension (48) incluant un transistor du type métal-isolant-semiconducteur (MIS) à canal N (T1) ayant un drain connecté à ladite borne d'alimentation (VDD), une source connectée à ladite ligne de sortie (L1), une grille et un corps semiconducteur (72-1) dont la région en surface sert de canal (76) dudit transistor MIS (T1) ; et
    un premier générateur de tension constante (52), connecté à ladite borne d'alimentation (VDD) pour générer une tension de sortie (VA) inférieure à ladite tension d'alimentation externe quand ladite tension d'alimentation externe est supérieure à une premier niveau prédéterminé et pour fournir la tension de sortie générée (VA) à la grille dudit transistor MIS (T1) dudit moyen d'abaissement de tension (48), fournissant ainsi à ladite ligne de sortie (L1) une tension d'alimentation interne (VI) qui est inférieure à la tension de sortie générée (VA) par la tension de seuil dudit transistor MIS (T1),
    caractérisé en ce que ledit corps semiconducteur (72-1) est connecté électriquement à la source dudit transistor MIS (T1).

2. Circuit régulateur de tension d'alimentation selon la revendication 1, caractérisé en ce que ledit premier générateur de tension constante (52) inclut un noeud de sortie connecté à la grille dudit transistor MIS (T1), un moyen d'augmentation de potentiel (T7) connecté entre ladite borne d'alimentation (VDD) et le noeud de sortie, un moyen de résistance variable dont une extrémité est connectée à ladite borne d'alimentation (VDD), pour fournir un courant en fonction du potentiel dudit noeud de sortie, un circuit de charge (T4, T5, T6) d'un type à miroir de courant ayant une charge d'entrée (T4) connectée à l'autre extrémité dudit moyen de résistance variable (T2) et une charge de sortie connectée au noeud de sortie.

3. Circuit régulateur de tension d'alimentation selon la revendication 2, caractérisé en ce que ladite ligne de sortie (L1) est connectée à un circuit intégré (32) servant de charge et en ce que ledit premier générateur de tension constante (52) est sensible à un signal de validation de circuit (CE) qui est fourni quand ledit circuit intégré (32) est rendu actif.

4. Circuit régulateur de tension d'alimentation selon la revendication 3, caractérisé en ce que ledit moyen de résistance variable inclut un transistor MIS à canal N (T2), ledit circuit de charge inclut une paire de premier et second transistors MIS à canal N (T4, T5) en tant que lesdites charges d'entrée et de sortie et un troisième transistor MIS à canal N (T6), et en ce que ledit moyen d'augmentation de potentiel inclut un transistor MIS à canal P (T7).

5. Circuit régulateur de tension d'alimentation selon la revendication 4, caractérisé en ce que le transistor MIS à canal N (T2) dudit moyen de résistance variable comprend une grille connectée audit noeud de sortie et un drain connecté à ladite borne d'alimentation (VDD), le premier transistor MIS à canal N (T4) dudit circuit de charge comprend un drain connecté de façon à recevoir un courant de drain provenant du transistor MIS (T2) dudit moyen de résistance variable et une grille connectée au drain de celui-ci, le second transistor MIS à canal N (T5) dudit circuit de charge comprend un drain connecté audit noeud de sortie et une grille connectée au drain dudit premier transistor MIS à canal N (T4), le troisième transistor MIS à canal N (T6) dudit circuit de charge comprend une voie de courant dont une extrémité est connectée aux sources desdits premier et second transistors MIS à canal N (T4, T5) et dont l'autre extrémité est reliée à la masse et une grille connectée de façon à recevoir un signal de validation de circuit (CE), et ledit transistor MIS à canal P (T7) dudit moyen d'élévation de potentiel comprend une voie de courant connectée entre ladite borne d'alimentation (VDD) et ledit noeud de sortie et une grille connectée de façon à recevoir un signal inversé par rapport audit signal de validation de circuit (CE).

6. Circuit régulateur de tension d'alimentation selon la revendication 1, caractérisé en ce qu'il comprend en outre un second générateur de tension constante (54) pour générer une tension de sortie (VB) supérieure à la tension de sortie (VA) dudit premier générateur de tension constante (52) lorsque la tension d'alimentation externe est supérieure à un second niveau prédéterminé qui est supérieur audit premier niveau prédéterminé et à un niveau standard de ladite tension d'alimentation externe.

7. Circuit régulateur de tension d'alimentation selon la revendication 6, caractérisé en ce que ledit second générateur de tension constante (54) inclut un noeud de sortie qui est connecté à la grille dudit transistor MIS (T1) dudit moyen d'abaissement de tension (48), un moyen d'élévation de potentiel (T12) qui est connecté entre ladite borne d'alimentation (VDD) et le noeud de sortie du second générateur de tension constante (54) et un dispositif de commande (T8, T9, T10, T11) pour commander le moyen d'élévation de potentiel (T12) dudit second générateur de tension constante (54) en fonction de ladite tension d'alimentation externe.

8. Circuit régulateur de tension d'alimentation selon la revendication 7, caractérisé en ce que ledit moyen d'élévation de potentiel du second générateur de tension constante (54) est un transistor MIS à canal P (T12) qui a une source connectée à ladite borne d'alimentation (VDD), un drain connecté au noeud de sortie du second générateur de tension constante (54) et une grille, le dispositif de commande inclut un transistor MIS à canal P (T8) et une pluralité de transistors MIS à canal N (T9, T10, T11), ledit transistor MIS à canal P (T8) du dispositif de commande a une grille reliée à la masse, un drain connecté à ladite borne d'alimentation (VDD) et une source connectée à la grille dudit transistor MIS à canal P T12) du moyen d'élévation de potentiel dudit second générateur de tension constante (54), et lesdits transistors MIS à canal N (T9, T10, T11) du dispositif de commande ont des voies de courant qui sont connectées en série entre la source dudit transistor MIS à canal P (T8) du dispositif de commande et la masse.

9. Circuit régulateur de tension d'alimentation selon la revendication 1, caractérisé en ce qu'il comprend en outre un circuit de polarisation (56) pour appliquer une tension de polarisation d'attente à la grille dudit transistor MIS à canal N (T1) du moyen d'abaissement de tension.

10. Circuit régulateur de tension d'alimentation selon la revendication 9, caractérisé en ce que ledit circuit de polarisation (56) inclut des éléments résistifs connectés en série (R3, R4) pour diviser le potentiel de la ligne de sortie (L1) et un inverseur (62) sensible à la tension de sortie desdits éléments résistifs (R3, R4) pour générer une tension de sortie en tant que dite tension de polarisation d'attente.

## Patentansprüche

1. Leistungsspannungsreglerschaltung, umfassend:
   - eine Stromklemme (VDD) zum Abnehmen einer externen Leistungsspannung,
   - eine Ausgangsleitung (L1),
   - eine Spannungsabsenkeinheit (48) zum Absenken der externen Leistungsspannung, wobei die Spannungsabsenkeinheit (48) einen n-Kanal-MIS-Transistor (T1) mit einer an die Stromklemme (VDD) angeschlossenen Drainelektrode, einer mit der Ausgangsleitung (L1) verbundenen Sourceelektrode, einer Gateelektrode und einem Halbleiterkörper (72-1), dessen Oberflächenbereich als ein Kanal (76) des MIS-Transistors (T1) wirkt, aufweist, und
   - einen mit der Stromklemme (VDD) verbundenen ersten Konstantspannungsgenerator (52) zum Erzeugen einer Ausgangsspannung (VA), die niedriger ist als die externe Leistungsspannung, wenn die externe Leistungsspannung einen ersten vorbestimmten Pegel übersteigt, und zum Zuspeisen der erzeugten Ausgangsspannung (VA) zur Gateelektrode des MIS-Transistors (T1) der Spannungsabsenkeinheit (48), um damit der Ausgangsleitung (L1) eine interne Leistungsspannung (VI) zuzuspeisen, die um die Schwellenspannung des MIS-Transistors (T1) niedriger ist als die erzeugte Ausgangsspannung (VA),
dadurch gekennzeichnet, daß
- der Halbleiterkörper (72-1) elektrisch mit der Sourceelektrode des MIS-Transistors (T1) verbunden ist.

2. Leistungsspannungsreglerschaltung nach Anspruch 1, dadurch gekennzeichnet, daß der erste Konstantspannungsgenerator (52) einen mit der Gateelektrode des MIS-Transistors (T1) verbundenen Ausgangsknotenpunkt, eine zwischen die Stromklemme (VDD) und den Ausgangsknotenpunkt geschaltete Hochzieh- oder Pull-Up-Einheit (T7), eine mit der einen Seite mit der Stromklemme (VDD) verbundene variable Widerstandseinheit (T2) zum Zuspeisen eines Stroms entsprechend dem Potential des Ausgangsknotenpunkts, einen Lastkreis (T4, T5, T6) eines Stromspiegeltyps mit einer an die andere Seite der variablen Widerstandseinheit (T2) angeschlossenen Eingangslast (T4) und einer mit dem Ausgangsknotenpunkt verbundenen Ausgangslast aufweist.

3. Leistungsspannungsreglerschaltung nach Anspruch 2, dadurch gekennzeichnet, daß die Ausgangsleitung (L1) mit einer als Last dienenden integrierten Schaltung (32) verbunden ist und der erste Konstantspannungsgenerator (52) auf ein Chipfreigabesignal (CE) anspricht, das zugespeist wird, wenn die integrierte Schaltung (32) aktiviert wird.

4. Leistungsspannungsreglerschaltung nach Anspruch 3, dadurch gekennzeichnet, daß die variable Widerstandseinheit einen n-Kanal-MIS-Transistor (T2) aufweist, der Lastkreis ein Paar erster und zweiter n-Kanal-MIS-Transistoren (T4, T5) als Eingangsund Ausgangslasten und einen dritten n-Kanal-MIS-Transistor (T6) enthält und die Hochzieh- oder Pull-Up-Einheit einen p-Kanal-MIS-Transistor (T7) aufweist.

5. Leistungsspannungsreglerschaltung nach Anspruch 4, dadurch gekennzeichnet, daß der n-Kanal-MIS-Transistor (T2) der variablen Widerstandseinheit eine mit dem Ausgangsknotenpunkt verbundene Gateelektrode und eine mit der Stromklemme (VDD) verbundene Drainelektrode aufweist, der erste n-Kanal-MIS-Transistor (T4) des Lastkreises eine zum Abnehmen eines Drainstroms vom MIS-Transistor (T2) der variablen Widerstandseinheit geschaltete Drainelektrode und eine an dessen Drainelektrode angeschlossene Gateelektrode aufweist, der zweite n-Kanal-MIS-Transistor (T5) des Lastkreises eine mit dem Ausgangsknotenpunkt verbundene Drainelektrode und eine mit der Drainelektrode des ersten n-Kanal-MIS-Transistors (T4) verbundene Gateelektrode aufweist, der dritte n-Kanal-MIS-Transistor (T6) des Lastkreises eine Stromstrecke, die an der einen Seite mit den Sourceelektroden von erstem und zweitem n-Kanal-MIS-Transistor (T4, T5) verbunden und an der anderen Seite geerdet ist bzw. an Masse liegt, und eine zur Abnahme eines Chipfreigabesignals (CE) geschaltete Gateelektrode aufweist und der p-Kanal-MIS-Transistor (T7) der Hochzieh- oder Pull-Up-Einheit eine Stromstrecke, die zwischen die Stromklemme (VDD) und den Ausgangsknotenpunkt geschaltet ist, und eine zum Abnehmen eines invertierten Signals des Chipfreigabesignals (CE) geschaltete Gateelektrode aufweist.

6. Leistungsspannungsreglerschaltung nach Anspruch 1, gekennzeichnet durch einen zweiten Konstantspannungsgenerator (54) zum Erzeugen einer Ausgangsspannung (VB), die höher ist als die Ausgangsspannung (VA) des ersten Konstantspannungsgenerators (52), wenn die externe Leistungsspannung höher ist als ein zweiter vorbestimmter Pegel, der höher ist als der erste vorbestimmte Pegel und ein Standardpegel der externen Leistungsspannung.

7. Leistungsspannungsreglerschaltung nach Anspruch 6, dadurch gekennzeichnet, daß der zweite Konstantspannungsgenerator (54) einen mit der Gateelektrode des MIS-Transistors (T1) der Spannungsabsenkeinheit (48) verbundenen Ausgangsknotenpunkt, eine zwischen die Stromklemme (VDD) und den Ausgangsknotenpunkt des zweiten Konstantspannungsgenerators (54) geschaltete Hochzieh- oder Pull-Up-Einheit (T12) und einen Treiber (T8, T9, T10, T11) zum Ansteuern der Hochzieh- oder Pull-Up-Einheit (T12) des zweiten Konstantspannungsgenerators (54) nach Maßgabe der externen Leistungsspannung aufweist.

8. Leistungsspannungsreglerschaltung nach Anspruch 7, dadurch gekennzeichnet, daß die Hochzieh- oder Pull-Up-Einheit des zweiten Konstantspannungsgenerators (54) ein p-Kanal-MIS-Transistor (T12) mit einer mit der Stromklemme (VDD) verbundenen Sourceelektrode, einer mit dem Ausgangsknotenpunkt des zweiten Konstantspannungsgenerators (54) verbundenen Drainelektrode und einer Gateelektrode ist, der Treiber einen p-Kanal-MIS-Transistor (T8) und eine Anzahl von n-Kanal-MIS-Transistoren (T9, T10, T11) aufweist, der p-Kanal-MIS-Transistor (T8) des Treibers eine geerdete bzw. an Masse liegende Gateelektrode, eine mit der Stromklemme (VD) verbundene Drainelektrode und eine mit der Gateelektrode des p-Kanal-MIS-Transistors (T12) der Hochzieh- oder Pull-Up-Einheit des zweiten Konstantspannungsgenerators (54) verbundene Sourceelektrode aufweist und die n-Kanal-MIS-Transistoren (T9, T10, T11) des Treibers Stromstrecken aufweisen, die in Reihe zwischen die Sourceelektrode des p-Kanal-MIS-Transistors (T8) des Treibers und Masse geschaltet sind.

9. Leistungsspannungsreglerschaltung nach Anspruch 1, gekennzeichnet durch einen Vorspannkreis (56) zum Zuspeisen einer Bereitschaftsvorspannung zur Gateelektrode des n-Kanal-MIS-Transistors (T1) der Spannungsabsenkeinheit.

10. Leistungsspannungsreglerschaltung nach Anspruch 9, dadurch gekennzeichnet, daß der Vorspannkreis (56) in Reihe geschaltete Widerstandselemente (R3, R4) zum Teilen des Potentials der Ausgangsleitung (L1) und einen auf die Ausgangsspannung der Widerstandselemente (R3, R4) ansprechenden Inverter (62) zum Erzeugen einer Ausgangsspannung als die Bereitschaftsvorspannung aufweist.

F I G. 1

F I G. 2

F I G. 3

F I G. 4

F I G. 5

F I G. 6